(19) Europäisches Patentamt
European Patent Office
Office européen des brevets

(11) **EP 2 797 344 B1**

(12) **EUROPÄISCHE PATENTSCHRIFT**

(45) Veröffentlichungstag und Bekanntmachung des Hinweises auf die Patenterteilung:
**19.09.2018 Patentblatt 2018/38**

(51) Int Cl.:
**H04R 25/00** *(2006.01)*     *H04R 3/02* *(2006.01)*
*H03H 21/00* *(2006.01)*     *H04R 1/10* *(2006.01)*

(21) Anmeldenummer: **14157271.9**

(22) Anmeldetag: **28.02.2014**

(54) **Verfahren zur Steuerung einer Adaptionsschrittweite und Hörvorrichtung**

Method for controlling an adaption step size and hearing aid

Procédé de commande d'un pas d'adaptation et dispositif auditif

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.04.2013 DE 102013207403**

(43) Veröffentlichungstag der Anmeldung:
**29.10.2014 Patentblatt 2014/44**

(73) Patentinhaber: **Sivantos Pte. Ltd.**
**Singapore 539775 (SG)**

(72) Erfinder:
• **Rosenkranz, Tobias Daniel**
**91054 Erlangen (DE)**
• **Wurzbacher, Tobias**
**90768 Fürth (DE)**

(74) Vertreter: **FDST Patentanwälte**
**Nordostpark 16**
**90411 Nürnberg (DE)**

(56) Entgegenhaltungen:
**DE-A1-102010 025 918**     **US-A1- 2009 028 367**

## Beschreibung

Die vorliegende Erfindung betrifft ein Verfahren zur Steuerung einer Adaptionsschrittweite eines adaptiven Filters einer Hörvorrichtung für eine Rückkopplungsreduktion. Dabei wird ein Schallsignal durch ein Mikrofon der Hörvorrichtung aufgenommen und ein korrespondierendes Mikrofonsignal ausgegeben. Auf der Basis des Mikrofonsignals wird ein Hörsignal für einen Hörer erzeugt, und ein Rückkopplungssignal in dem Mikrofonsignal wird durch ein adaptives Filter reduziert. Darüber hinaus betrifft die vorliegende Erfindung eine entsprechende Hörvorrichtung. Unter einer Hörvorrichtung wird hier jedes im oder am Ohr tragbare, einen Schallreiz produzierende Gerät verstanden, insbesondere ein Hörgerät, ein Headset, Kopfhörer und dergleichen.

Hörgeräte sind tragbare Hörvorrichtungen, die zur Versorgung von Schwerhörenden dienen. Um den zahlreichen individuellen Bedürfnissen entgegenzukommen, werden unterschiedliche Bauformen von Hörgeräten wie Hinter-dem-Ohr-Hörgeräte (HdO), Hörgerät mit externem Hörer (RIC: receiver in the canal) und In-dem-Ohr-Hörgeräte (IdO), z.B. auch Concha-Hörgeräte oder Kanal-Hörgeräte (ITE, CIC), bereitgestellt. Die beispielhaft aufgeführten Hörgeräte werden am Außenohr oder im Gehörgang getragen. Darüber hinaus stehen auf dem Markt aber auch Knochenleitungshörhilfen, implantierbare oder vibrotaktile Hörhilfen zur Verfügung. Dabei erfolgt die Stimulation des geschädigten Gehörs entweder mechanisch oder elektrisch.

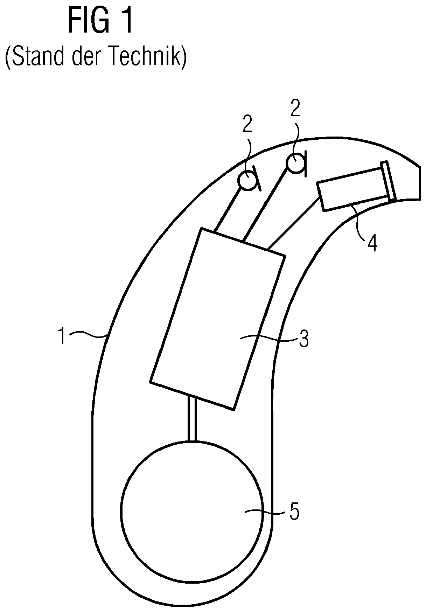

Hörgeräte besitzen prinzipiell als wesentliche Komponenten einen Eingangswandler, einen Verstärker und einen Ausgangswandler. Der Eingangswandler ist in der Regel ein Schallempfänger, z. B. ein Mikrofon, und/oder ein elektromagnetischer Empfänger, z. B. eine Induktionsspule. Der Ausgangswandler ist meist als elektroakustischer Wandler, z. B. Miniaturlautsprecher, oder als elektromechanischer Wandler, z. B. Knochenleitungshörer, realisiert. Der Verstärker ist üblicherweise in eine Signalverarbeitungseinheit integriert. Dieser prinzipielle Aufbau ist in FIG 1 am Beispiel eines Hinter-dem-Ohr-Hörgeräts dargestellt. In ein Hörgerätegehäuse 1 zum Tragen hinter dem Ohr sind ein oder mehrere Mikrofone 2 zur Aufnahme des Schalls aus der Umgebung eingebaut. Eine Signalverarbeitungseinheit 3, die ebenfalls in das Hörgerätegehäuse 1 integriert ist, verarbeitet die Mikrofonsignale und verstärkt sie. Das Ausgangssignal der Signalverarbeitungseinheit 3 wird an einen Lautsprecher bzw. Hörer 4 übertragen, der ein akustisches Signal ausgibt. Der Schall wird gegebenenfalls über einen Schallschlauch, der mit einer Otoplastik im Gehörgang fixiert ist, zum Trommelfell des Geräteträgers übertragen. Die Energieversorgung des Hörgeräts und insbesondere die der Signalverarbeitungseinheit 3 erfolgt durch eine ebenfalls ins Hörgerätegehäuse 1 integrierte Batterie 5.

Audiosysteme bzw. Hörvorrichtungen, wie sie hier von Belang sind, besitzen mindestens ein Mikrofon zum Aufnehmen von Umgebungsschall, eine nachgeschaltete Signalverarbeitungseinheit zum Verarbeiten des Mikrofonsignals (z.B. Verstärkung) und einen Lautsprecher bzw. Hörer, an den das verarbeitete Mikrofonsignal geschickt wird und der ein entsprechendes Schallsignal an die Umgebung abgibt. Ein besonderes Problem derartiger Hörvorrichtungen besteht darin, dass akustische Rückkopplungen auftreten, die es zu eliminieren gilt. Rückkopplungen an Hörvorrichtungen äußern sich in der Regel durch störendes Rückkopplungspfeifen.

Eine akustische Rückkopplung tritt auf, wenn der vom Hörer abgestrahlte Schall durch das Mikrofon wieder in die Hörvorrichtung eintritt und verstärkt wird. Es ergibt sich dabei die geschlossene Schleife: Mikrofon - Verstärkung - Hörer - Mikrofon - usw. Rückkopplungspfeifen resultiert, wenn die Verstärkung über einem gewissen Schwellwert liegt.

Das unerwünschte Pfeifen kann durch eine Rückkopplungsreduktionseinheit reduziert oder sogar eliminiert werden. Bekannt sind bislang adaptive Rückkopplungsreduktionsverfahren, bei denen ein adaptives Filter die zeitvariante Impulsantwort g des akustischen Rückkopplungspfads modelliert. Ein allgemeines Beispiel für eine Adaptionsregel für das Aktualisieren der Filterkoeffizienten h ist der Algorithmus des normalisierten, kleinsten Fehlerquadrats (NLMS):

$$h(k+1) = h(k) + \mu\,[\,(e\#(k))\,x(k))\,/\,(x\#(k)\,x(k))\,]$$

Dabei repräsentiert k den diskreten Zeitindex, x das Eingangssignal für die Rückkopplungsreduktionseinheit, e=m-c das als die Differenz des Mikrofonsignals m und des Rückkopplungskompensationssignals c definierte Fehlersignal, μ den die Adaptionsgeschwindigkeit steuernden Schrittweitenparamter und # die konjugiert komplexe Operation. Die hier verwendeten Größen sind im Allgemeinen komplexwertig und stellen insbesondere Frequenzbereichsgrößen dar.

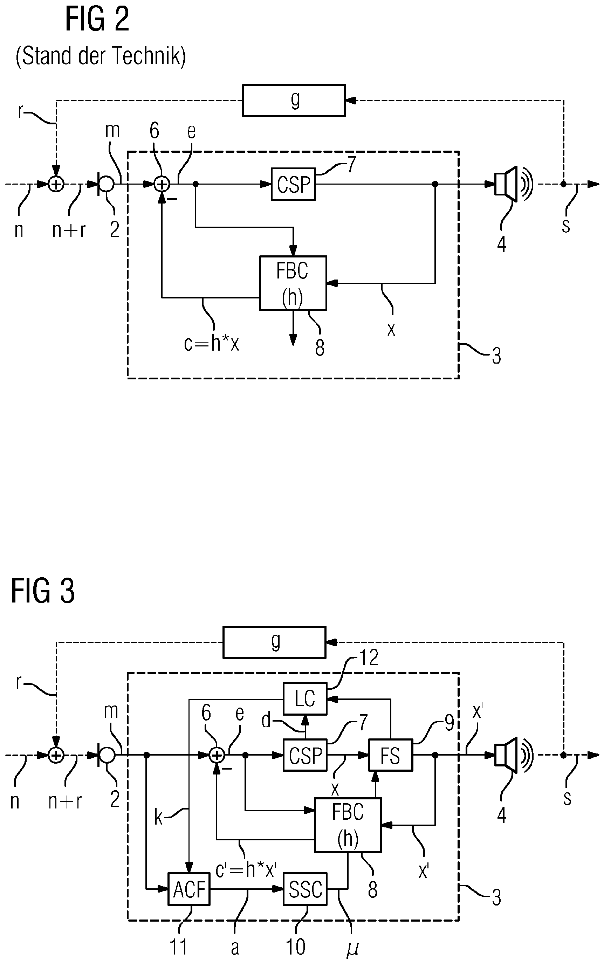

FIG 2 zeigt ein Blockschaltbild einer bekannten Technik zur Rückkopplungsreduktion bei einem Hörgerät. Ein Mikrofon 2 nimmt ein Schallsignal auf und generiert daraus ein entsprechendes Mikrofonsignal m. Dieses Mikrofonsignal m wird einer Signalverarbeitungseinrichtung 3 zugeführt. Das Ausgangssignal x der Signalverarbeitungseinrichtung 3 wird einem Hörer 4 zugeführt. Dieser produziert ein Ausgangsschallsignal s, das für ein Ohr eines Hörgeräteträgers bzw. eines Nutzers der Hörvorrichtung bestimmt ist. Ein Teil des Ausgangsschallsignals s wird als Rückkopplungssignal r an den Eingang des Hörgeräts bzw. der Hörvorrichtung rückgekoppelt. Der Rückkopplungspfad besitzt die Übertragungsfunktion g. Eingangsseitig wird ein Nutzsignal n mit dem Rückkopplungssignal r addiert, und das Summensignal n+r bildet das Eingangsschallsignal für das Mikrofon 2.

In der Signalverarbeitungseinrichtung 3 wird mittels eines Addierers 6 von dem Mikrofonsignal m ein Kompensationssignal c subtrahiert, indem das negative Signal -c zu dem Mikrofonsignal m addiert wird. Es resultiert das Fehlersignal e, das einer zentralen Verarbeitungseinheit 7 (CSP) zugeführt wird, welche das Ausgangssignal x produziert. Das Ausgangssignal x wird einem Rückkopplungskompensator 8 (FBC) zugeführt. Dieser besitzt die Übertragungsfunktion h, welche als Schätzgröße für die Übertragungsfunktion g des Rückkopplungspfads gilt. Das Ausgangssignal des Rückkopplungskompensators 8 ist das Kompensationssignal c, das sich somit darstellt als: c=h*x, wobei * die Faltungsoperation beschreibt. Der Rückkopplungskompensator 8 wird außerdem mit dem Fehlersignal e gesteuert. Insgesamt wird somit das Rückkopplungssignal r durch das Kompensationssignal c kompensiert, sodass störendes Rückkopplungspfeifen beseitigt wird.

Details zur Funktionsweise und zum Aufbau derartiger Hörvorrichtungen mit Rückkopplungsunterdrückung bzw. Rückkopplungsreduktion sind in dem Buch S. Haykin: "Adaptive Filter Theory", Englewood Cliffs, NJ: Prentice Hall, 1999, Kapitel 6 "Normalized Least-Mean-Square Adaptive Filters", Seiten 320 bis 324 beschrieben. Darüber hinaus wird auch auf den Artikel Toon van Waterschoot and Marc Moonen, "Fifty years of acoustic feedback control: state of the art and future challenges", Proc. IEEE, vol. 99, no. 2, Feb. 2011, Seiten 288-327 verwiesen.

Der Rückkopplungskompensator 8 ist üblicherweise als adaptives Filter realisiert. Mit einem Parameter $\mu$, der auch als Schrittweite bezeichnet wird, lässt sich die Adaptionsgeschwindigkeit des Filters steuern. Eine geeignete zeitabhängige Steuerung der Schrittweite $\mu$ ist für ein wirkungsvolles und stabiles Rückkopplungskompensationsverhalten erforderlich. Wenn die Schrittweite $\mu$ groß ist, adaptiert das Filter rasch an neue Situationen des akustischen Rückkopplungspfads g, wodurch Rückkopplungspfeifen verhindert wird. Andererseits führt eine große Schrittweite $\mu$ zu deutlichen Fehladaptionen, die unliebsame Artefakte hervorrufen, wenn das Eingangssignal korreliert ist, d.h. die Autokorrelationsfunktion von Null verschieden ist. Dies ist insbesondere bei tonalen Eingangssignalen der Fall.

Ist hingegen die Schrittweite $\mu$ klein, können diese Artefakte im Wesentlichen verhindert bzw. reduziert werden. Der Preis dafür ist jedoch eine sehr beschränkte Fähigkeit, auf Änderungen des Rückkopplungspfads zu reagieren.

In der DE 10 2010 025 918 A1 ist für ein Hörgerät offenbart, ein Hörersignal, welches von einem Hörer in ein akustisches Ausgangssignal zu wandeln ist, vor besagter Umwandlung zwei unterschiedliche Frequenzverschiebungen anzuwenden. Hierbei erfolgt die eine Frequenzverschiebung konstant um einen derart geringen Wert, dass schwache Rückkopplungen unterdrückt werden, ohne dass dabei jedoch Artefakte auftreten, während der Wert der anderen Frequenzverschiebung in Abhängigkeit einer auftretenden Rückkopplung gesteuert wird.

Die US 2009 / 0 028 367 A1 zeigt, in einem Hörgerät die Signalverarbeitung und insbesondere eine Reduktion einer Samplerate des Eingangssignals in Abhängigkeit von dessen Autokorrelation zu steuern.

Die Aufgabe der vorliegenden Erfindung besteht somit darin, ein Verfahren zur Steuerung einer Adaptionsgeschwindigkeit eines adaptiven Filters einer Hörvorrichtung vorzuschlagen, mit dem eine verbesserte Schallqualität des Ausgangsschalls bei Änderungen des Rückkopplungspfads möglich ist. Darüber hinaus soll eine entsprechende Hörvorrichtung angegebene werden.

Erfindungsgemäß wird diese Aufgabe gelöst durch ein Verfahren zur Steuerung einer Adaptionsschrittweite eines adaptiven Filters einer Hörvorrichtung für eine Rückkopplungsreduktion durch

- Aufnehmen eines Schallsignals durch ein Mikrofon der Hörvorrichtung und Ausgeben eines korrespondierenden Mikrofonsignals,
- Erzeugen eines Hörersignals für einen Hörer der Hörvorrichtung auf der Basis des Mikrofonsignals und
- Reduzieren eines Rückkopplungssignals in dem Mikrofonsignal durch das adaptive Filter,
- Gewinnen eines Autokorrelationswerts von Abtastwerten des Mikrofonsignals, zwischen denen eine Zeitdifferenz besteht,
- Steuern der Adaptionsschrittweite des adaptiven Filters anhand des Autokorrelationswerts,
- Verschieben einer Frequenz eines auf der Basis des Mikrofonsignals gewonnenen Ausgangssignals bei dem Erzeugen des Hörersignals, und
- Steuern der Zeitdifferenz für das Gewinnen des Autokorrelationswerts in Abhängigkeit von dem Verschieben der Frequenz des Ausgangssignals,

wobei die Adaptionsschrittweite ausgehend von einem Anfangswert nur dann reduziert wird, wenn der Autokorrelationswert nach einer Normierung mit dem Normkorrelationswert, der sich bei der Zeitdifferenz Null ergibt, in einem vorgegebenen Bereich um Eins liegt.

Darüber hinaus wird erfindungsgemäß bereitgestellt eine Hörvorrichtung mit

- einem Mikrofon zum Aufnehmen eines Schallsignals und Ausgeben eines korrespondierenden Mikrofonsignals,
- einem Hörer,
- einer Signalverarbeitungseinrichtung zum Erzeugen eines Hörersignals für den Hörer auf der Basis des Mikrofonsignals und

- einem adaptiven Filter zum Reduzieren eines Rückkopplungssignals in dem Mikrofonsignal, sowie umfassend

- eine Autokorrelationseinheit zum Gewinnen eines Autokorrelationswerts von Abtastwerten des Mikrofonsignals, zwischen denen eine Zeitdifferenz besteht, und

- eine Steuereinrichtung zum Steuern einer Adaptionsschrittweite des adaptiven Filters anhand des Autokorrelationswerts, wobei

- von der Signalverarbeitungseinrichtung eine Frequenz eines auf der Basis des Mikrofonsignals gewonnen Ausgangssignals bei dem Erzeugen des Hörersignals verschiebbar ist,

- in der Autokorrelationseinheit die Zeitdifferenz für das Gewinnen des Autokorrelationswerts in Abhängigkeit von dem Verschieben der Frequenz des Ausgangssignals steuerbar ist, und

- in der Steuereinrichtung die Adaptionsschrittweite ausgehend von einem Anfangswert reduzierbar ist, wenn der Autokorrelationswert nach einer Normierung mit dem Normkorrelationswert, der sich bei der Zeitdifferenz Null ergibt, in einem vorgegebenen Bereich um Eins liegt.

In vorteilhafter Weise erfolgt durch die Frequenzverschiebung eine Dekorrelation von Mikrofon- und Ausgangssignal. Rückkopplungsbedingtes Pfeifen hat somit nur noch sehr geringen tonalen Charakter, was sich in kleinen Autokorrelationswerten widerspiegelt. Abhängig vom Autokorrelationswert wird dann die Schrittweite für das adaptive Filter gesteuert. Damit ergibt sich ein neues Steuerungskonzept für die Schrittweite $\mu$, die die Adaptionsgeschwindigkeit gegebenenfalls in Teilbändern optimal steuert, um insbesondere bei tonalen Signalen eine gute Schallqualität ohne Artefakte zu erreichen, während in allen anderen Situationen die Möglichkeit erhalten bleibt, auf Änderungen des Rückkopplungspfads rasch zu reagieren.

Das Erzeugen des Hörersignals, d.h. des Ausgangssignals für den Hörer, aus dem Mikrofonsignal beispielsweise durch eine zentrale Signalverarbeitungseinheit kann mit einer Zeitverzögerung erfolgen, die zum Steuern der Zeitdifferenz für das Gewinnen des Autokorrelationswerts herangezogen wird. Damit werden die internen Signalverarbeitungsbedingungen für die Schrittweitensteuerung berücksichtigt.

Vorzugsweise erfolgt das Steuern der Zeitdifferenz für das Gewinnen des Autokorrelationswerts derart, dass der Autokorrelationswert bei rückkopplungsbedingtem Pfeifen unter einem vorgegebenen Schwellwert liegt. Günstigerweise liegt der Schwellwert unter 60 % des maximalen Autokorrelationswerts. Hierdurch lassen sich Rückkopplungssignale deutlicher von tonalen Signalen unterscheiden, welche durch höhere Autokorrelationswerte charakterisiert sind

Darüber hinaus kann das Steuern der Zeitdifferenz für das Gewinnen des Autokorrelationswerts derart erfolgen, dass der Autokorrelationswert im Fall von Rückkopplungspfeifen ein Minimum annimmt. Hierdurch lässt sich eine besonders klare Unterscheidungsmöglichkeit zwischen Rückkopplungssignalen und tonalen Signalen realisieren.

Ferner kann das Steuern der Zeitdifferenz für das Gewinnen des Autokorrelationswerts dynamisch mit einer Änderung des Verschiebens der Frequenz des Mikrofonsignals erfolgen. Dabei kann die variable Frequenzverschiebung situationsbedingt entweder verringert oder erhöht werden. Das erfindungsgemäße Verfahren ist somit insbesondere auch dann anwendbar, wenn zur Vermeidung von Frequenzverschiebungs-Artefakten zeitweise auf eine Frequenzverschiebung verzichtet wird.

Besonders vorteilhaft ist, wenn das Verfahren zur Steuerung der Adaptionsschrittweite in mehreren Frequenzteilbändern parallel, jeweils unabhängig voneinander durchgeführt wird. Damit lässt sich die Adaption des Filters in allen Frequenzbereichen optimal realisieren.

Des Weiteren kann die Adaptionsschrittweite ausgehend von einem Anfangswert nur dann reduziert werden, wenn der Autokorrelationswert nach einer Normierung mit dem Normkorrelationswert, der sich bei der Zeitdifferenz Null ergibt, in einem vorgegebenen Bereich um/nahe Eins liegt. Wenn der Autokorrelationswert trotz der dekorrelierenden Wirkung der Frequenzverschiebung nahe Eins liegt, muss ein tonales Eingangssignal vorliegen. In diesem Fall ist es dann von Vorteil, wenn die Adaptionsschrittweite reduziert wird, um Fehlanpassungen zu vermeiden.

Gemäß einer weiteren Ausgestaltung wird der Autokorrelationswert nicht von Abtastwerten des Mikrofonsignals, sondern von Abtastwerten eines Fehlersignals gewonnen, das einer Differenz zwischen dem Mikrofonsignal und einem Korrektursignal bzw. Kompensationssignal des adaptiven Filters entspricht. Dies stellt eine signaltechnische Variante zum Gewinnen des Autokorrelationswerts aus den Abtastwerten des Mikrofonsignals dar.

Die erfindungsgemäße Hörvorrichtung kann insbesondere als Hörgerät ausgebildet sein.

Die oben beschriebenen Verfahrensmerkmale können auch mit entsprechenden Mitteln in einer Hörvorrichtung realisiert sein. Im Verfahren wie auch in der Hörvorrichtung können die oben beschriebenen Merkmale, soweit sinnvoll, miteinander kombiniert, aber auch in Alleinstellung verwendet werden. Das Gleiche gilt für die im Folgenden in Zusammenhang mit den Zeichnungen beschriebenen Merkmale der Ausführungsbeispiele.

Die vorliegende Erfindung wird anhand der beigefügten Zeichnungen näher erläutert, in denen zeigen:

FIG 1     den prinzipiellen Aufbau eines Hörgeräts gemäß dem Stand der Technik;

FIG 2    ein Blockschaltbild eines bekannten Hörgeräts mit Rückkopplungsunterdrückung;

FIG 3    ein Blockschaltbild eines Hörgeräts mit Schrittweitensteuerung für die Rückkopplungsunterdrückung gemäß der vorliegenden Erfindung; und

FIG 4    die Autokorrelation des Rückkopplungssignals in einem Teilband über der Zeitdifferenz zwischen zwei Signalabtastwerten.

Die nachfolgend näher geschilderten Ausführungsbeispiele stellen bevorzugte Ausführungsformen der vorliegenden Erfindung dar.

Es gibt grundsätzlich zwei Prinzipien, die bei der Schrittweitensteuerung auf die Problematik korrelierter Eingangssignale eingehen:

a) Die Basisschrittweite wird gering gehalten, um eine Fehlanpassung zu vermeiden, wodurch die Schallqualität auf einem hohen Niveau gehalten wird. Die Schrittweite wird erhöht, wenn Rückkopplungspfeifen detektiert wird, sodass sich das Filter rasch an die Situation anpassen kann. Bei diesem Ansatz gibt es zwei Probleme: (1) Das Filter kann nur adaptiert werden, wenn Rückkopplungspfeifen auftritt, was aber bedeutet, dass der Träger der Hörvorrichtung bzw. des Hörgeräts das unangenehme Rückkopplungspfeifen wahrnimmt, bis das Filter ausreichend adaptiert ist. (2) Ohne weitere Hilfsmittel ist es tatsächlich unmöglich zwischen Rückkopplungspfeifen und einem externen tonalen Schallsignal zu unterscheiden, weswegen die Schrittweite bei tonalem Eingangsschall oft erhöht wird. Dies führt meist zu Fehlanpassungen des Filters und zu gravierenden Artefakten. Ein weiteres Hilfsmittel zum Unterscheiden zwischen einem Rückkopplungsschallsignal und einem externen tonalen Schallsignal kann eine (nicht hörbare) Phasenmodulation des Hörersignals sein. Wenn diese Modulation in dem Eingangssignal detektiert wird, deutet dies mit hoher Wahrscheinlichkeit auf Rückkopplungspfeifen hin. Dieses Verfahren braucht einige hundert Millisekunden, um die Modulation hinreichend zu detektieren. Ein derart lang andauerndes Rückkopplungspfeifen ist für den Hörgeräteträger inakzeptabel.

b) Die Basisschrittweite wird hochgehalten, sodass fast kein Rückkopplungspfeifen auftreten kann. Die Schrittweite wird immer dann reduziert, wenn ein tonales Schallsignal detektiert wird, da tonale Schallsignale zu Fehladaptionen führen. Dieser Ansatz birgt das Risiko einer zu langsamen Anpassung an die Rückkopplung, wenn Rückkopplungspfeifen trotz der großen Schrittweite auftritt, da die Schrittweite im Falle des Rückkopplungspfeifens (irrtümlich) reduziert werden würde. Um diesem ungewollten Verhalten entgegenzuwirken, wäre eine verlässliche und rasche Detektion des Rückkopplungspfeifens erforderlich.

Rückkopplungsdetektoren können auf verschiedene Arten implementiert werden. Bei einfacher Ausgestaltung suchen sie nach Spitzen im Eingangsspektrum. Ein anderes Verfahren besteht darin, die Autokorrelationsfunktion (ACF) des Eingangssignals zu schätzen. Eine hohe Autokorrelation bei einer von Null verschiedenen Zeitdifferenz zwischen den Abtastwerten deutet auf ein tonales Signal hin. Beide Verfahren können aber nicht zwischen externen tonalen Eingangssignalen und Rückkopplungspfeifen unterscheiden.

Dieses Dilemma wird durch den nachfolgend geschilderten erfindungsgemäßen Ansatz gelöst. Dieser neue Ansatz basiert beispielsweise auf einer Teilbandverarbeitung im Frequenzbereich, realisiert beispielsweise durch eine Kurzzeit-FourierTransformation oder eine Polyphasen-Filterbank. Die Basisschrittweite wird hoch gehalten, sodass sich das Filter sehr rasch an Änderungen des Rückkopplungspfads anpassen kann. Bei einem tonalen Eingangssignal wird die Schrittweite reduziert. Ein tonales Eingangssignal wird durch einen hohen Autokorrelationswert (ACF-Wert) des Eingangssignals angedeutet. Der ACF-Wert des Eingangssignals wird hier in jedem Teilband geschätzt. Der ACF-Wert eines (komplexen) Signals $x(n)$ zum Zeitpunkt n ist für eine Zeitdifferenz k definiert als $ACF(n,k)=E\{x(n)x(n-k)\#\}$.

Dabei bedeutet $E\{\}$ den Erwartungswertoperator und $x\#$ bedeutet die konjugiert Komplexe von x. Das Symbol $x(n)$ ist hier als Stellvertreter eines beliebigen Signals zu sehen und nicht zwangsläufig mit dem Hörersignal x von FIG 2 gleichzusetzen. Im vorliegenden Beispiel wird vielmehr das Signal $x(n)$ dem Mikrofonsignal m entsprechen.

In der Praxis wird der Erwartungswert durch den Mittelwert über der Zeit angenähert, was auch rekursiv erfolgen kann. Dabei ist es vorteilhaft, die ACF-Werte durch Division jedes Werts durch den Wert bei der Zeitdifferenz Null zwischen den Abtastwerten zu normalisieren. Alle Werte befinden sich somit im Bereich von [-1, 1]. Ein tonales Eingangssignal bzw. Eingangsschallsignal in einem Teilband des gesamten zu verarbeitenden Frequenzbands kann hinreichend genau als eine Sinusschwingung in diesem Teilband beschrieben werden. Im Frequenzbereich entspricht diese Sinusschwingung der komplexen Zahl $Ae^{(-j\varphi)}$, wobei A die Amplitude und $\varphi$ die Phase bedeuten. Der Absolutwert des normalisierten ACF-Werts dieser Sinusschwingung bei beliebiger Zeitdifferenz k beträgt immer Eins, da die Amplitude zu Eins normalisiert ist, und das Produkt zweier komplexer Exponentialwerte immer den Absolutwert Eins besitzt. Folglich deuten Werte in der Nähe von Eins auf tonale Eingangssignale hin.

Es ist vorteilhaft, die Schrittweite des Rückkopplungskompensators in jedem einzelnen Frequenzteilband individuell zu steuern. Die Möglichkeit, auf Änderungen des Rückkopplungspfads rasch zu reagieren steht dann in allen Teilbändern zur Verfügung, die keine tonalen Signale enthalten.

Anhand von FIG 3 wird nun ein konkreter Aufbau eines Hörgeräts mit erfindungsgemäßer Schrittweitensteuerung des adaptiven Filters für die Rückkopplungskompensation beispielhaft erläutert. Dieses Beispiel ist ebenso auf andere Hörvorrichtungen übertragbar. Das Blockschaltbild von FIG 3 symbolisiert auch das entsprechende erfindungsgemäße Verfahren in einem konkreten Beispiel.

Um ein externes tonales Signal von Rückkopplungspfeifen zu unterscheiden, wird das Ausgangssignal x der zentralen Signalverarbeitungseinheit 7 um eine gewisse Differenzfrequenz im Frequenzbereich verschoben. Die Frequenzverschiebung ist für die Rückkopplungsunterdrückung vorteilhaft, da sie das Eingangssignal und das Ausgangssignal der Hörvorrichtung dekorreliert. Zu diesem Zweck ist nun der Hauptsignalpfad zwischen der zentralen Signalverarbeitungseinheit 7 und dem Hörer 4 durch eine Frequenzverschiebungseinheit 9 (FS) ergänzt. Der Aufbau der Hörvorrichtung basiert dabei auf dem Aufbau von FIG 2. Es wird daher auf die dortige Beschreibung verwiesen.

Das Ausgangssignal x der zentralen Signalverarbeitungseinheit 7 wird also zunächst der Frequenzverschiebeeinheit 9 zugeführt. Das resultierende Signal x' stellt dann das Hörersignal für den Hörer 4 dar. Dieses Hörersignal x' wird an den Rückkopplungskompensator 8 geleitet, dessen Ausgangssignal nun das veränderte Kompensationssignal c'=h·x' darstellt. Wie im Fall von FIG 2 wird auch das Kompensationssignal c' mit Hilfe des Addieres 6 negativ zu dem Mikrofonsignal m addiert, d.h. von ihm subtrahiert, um das Fehlersignal e zu erhalten.

Der Rückkopplungskompensator 8 besitzt nun nicht wie im Beispiel von FIG 2 eine feste Schrittweite für die Adaption, sondern eine variable Schrittweite $\mu$. Diese variable Schrittweite $\mu$ wird von einer Schrittweitensteuereinheit 10 (SSC) der Signalverarbeitungseinrichtung 3 dynamisch angepasst. Dazu erhält die Schrittweitensteuereinheit 10 von einer Autokorrelationseinheit 11 (ACF), die ebenfalls in die Signalverarbeitungseinrichtung 3 integriert ist, einen Autokorrelationswert a. Der Autokorrelationswert a wird gemäß obiger Formel aus dem Mikrofonsignal m gebildet. Insbesondere wird er aus Abtastwerten gebildet, die um die Zeitdifferenz k zeitlich voneinander beabstandet sind. Diese Zeitdifferenz k liefert eine Zeitsteuereinheit 12 (LC) der Signalverarbeitungseinrichtung 3. Die Zeitsteuereinheit 12 erhält hierzu Daten (insbesondere den Verschiebebetrag bzw. die Differenzfrequenz für die Frequenzverschiebung) von der Frequenzverschiebeeinheit 9. Sind diese Größen a priori bekannt und zeitinvariant, kann die Zeitdifferenz k auch in optimaler Weise fest eingestellt werden. Optional kann zur Ermittlung der Zeitdifferenz k für die Autokorrelation auch beispielsweise ein Verzögerungswert d von der zentralen Signalverarbeitungseinheit 7 herangezogen werden. Dies bedeutet also, dass in Abhängigkeit von der Verschiebefrequenz die Zeitdifferenz für die Autokorrelation bestimmt wird. Aus dem Autokorrelationswert a wird dann die Schrittweite $\mu$ für das adaptive Filter der Rückkopplungsreduktionseinheit 8 bestimmt.

Wenn nun Rückkopplungspfeifen auftritt, wird dieses Pfeifen durch das Mikrofon wieder aufgenommen und in der Frequenz verschoben. Der verschobene Pfeifton wird wieder aufgenommen und erneut verschoben. Es ergibt sich damit ein zu höheren Frequenzen immer wiederholendes Spektogrammmuster. Die Frequenzverschiebung führt zu nach oben oder unten weisenden Spektrallinien.

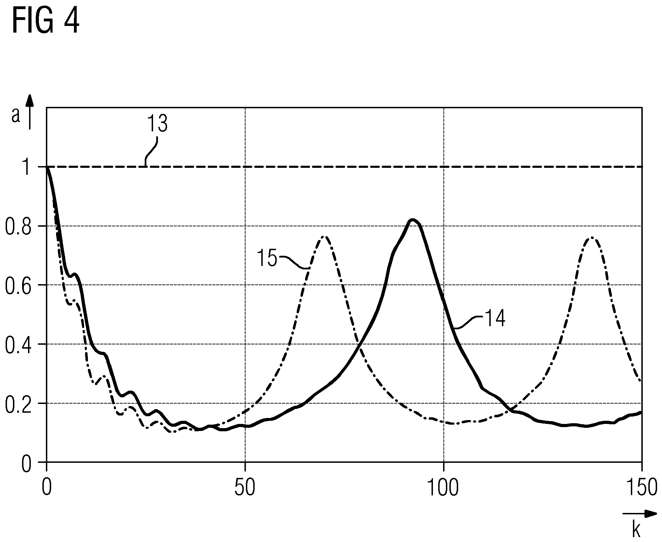

Die Amplitude des Autokorrelationswerts a eines solchen Signals ist für die verschiedenen Zeitdifferenzen in der Regel nicht nahe Eins. Sie ist nur für gewisse Zeitdifferenzen in periodischem Abstand verhältnismäßig hoch (nahe Eins) wie dies FIG 4 zu entnehmen ist. Dort ist der Autokorrelationswert a bei Rückkopplung über der Zeitdifferenz k aufgetragen. Für einen reinen Sinuston - wie er auch durch Rückkopplungspfeifen ohne Frequenzverschiebung entstehen würde - als Mikrofonsignal m ergibt sich der konstante Autokorrelationswert a=1 gemäß der Gerade 13. Wird nun das Ausgangssignal x um die Frequenz f1 verschoben, folgt der Autokorrelationswert a der Kurve 14. Bei einer Frequenzverschiebung f2 ergibt sich die Kurve 15, wobei f1 < f2 ist.

Die Periodenzeit jeder Kurve 14, 15 wird durch die Verzögerung bestimmt, die durch die Signalverarbeitung gegeben ist, aber auch durch den Rückkopplungspfad und die Verschiebefrequenz. Die Schrittweite wird nun nur reduziert, wenn die Amplitude des Autokorrelationswerts a nahe Eins liegt, was für bestimmte Zeitdifferenzen k der Fall ist. Um zu entscheiden, ob der Autokorrelationswert "nahe Eins" liegt, kann ein Schwellwert herangezogen werden. Beispielsweise wird diese Entscheidung bejaht, wenn der Autokorrelationswert a über 0,6 bzw. 60 % liegt. Die Zeitdifferenz k wird also in Abhängigkeit von der Verschiebefrequenz und der Verarbeitungsverzögerung so gewählt, dass das Rückkopplungspfeifen bei der jeweiligen Zeitdifferenz k keine Autokorrelationswerte a in der Nähe von Eins liefert. Vorzugsweise werden also Zeitdifferenzen k gewählt, bei denen der Autokorrelationswert sehr klein ist und insbesondere ein Minimum annimmt. Damit ist das Steuerungsverfahren nicht mehr empfindlich gegenüber Rückkopplungspfeifen, und die hohe Adaptionsrate (große Schrittweite) wird beibehalten, auch wenn Rückkopplungspfeifen auftreten sollte.

In dem obigen Ausführungsbeispiel gemäß FIG 3 wird der Autokorrelationswert a aus dem Mikrofonsignal m berechnet. In einer alternativen Ausführungsform wird der Autokorrelationswert a aus dem Fehlersignal e berechnet.

In vorteilhafter Weise arbeitet das Verfahren gemäß obigen Ausführungsbeispielen deutlich schneller als bekannte Verfahren, die auf Modulationsdetektion basieren. Das erfindungsgemäße Verfahren ist außerdem in der Lage, sehr rasch (in nur wenigen Millisekunden) zu reagieren. Abhängig von der Konfiguration können so Antwortzeiten unter 10ms erreicht werden. Einfache Rückkopplungsdetektoren wie sie zum Detektieren tonaler Signale verwendet werden, die nur nach spektralen Spitzen suchen, wären nicht in der Lage, zwischen externen, tonalen Signalen und Rückkopplungspfeifen zu unterscheiden, da das oben beschriebene Spektrogrammmuster des Rückkopplungspfeifens typischerweise eine geringe Bandbreite aufweist und daher wegen der begrenzten Auflösung von Filterbänken üblicherweise nicht durch reine Spitzenwertsuche unterscheidbar ist.

In dem obigen Ausführungsbeispiel wird also in einem Rückkopplungskompensator, der in einem Frequenzbereich arbeitet, eine ACF-regulierte Schrittweitensteuerung zusammen mit einer Frequenzverschiebung, die es ermöglicht, zwischen Rückkopplungspfeifen und externen tonalen Signalen zu unterscheiden, angewendet. Außerdem wird die Verarbeitungsverzögerung und die Frequenzverschiebung herangezogen, um den Autokorrelationswert bei einer geeigneten Zeitdifferenz k zu bestimmen. Die Erfindung ermöglicht den Einsatz eines Rückkopplungskompensators in einem Modus mit sehr hoher Rückkopplungsunterdrückungsleistung, wobei sehr rasch auf Änderungen des Rückkopplungspfads reagiert werden kann. Bei korrekter Identifikation externer tonaler Signale kann die Adaptionsgeschwindigkeit in denjenigen Zeit-Frequenz-Bereichen reduziert werden, die externe tonale Signalkomponente enthalten. Somit lässt sich Fehladaption des Rückkopplungsunterdrückungsfilters verhindern, was zu einer deutlichen Verbesserung der Schallqualität gegenüber einem Rückkopplungskompensator führt, der ständig mit hoher Adaptionsgeschwindigkeit betrieben wird. Der erfindungsgemäße Ansatz ist ferner unempfindlich gegenüber Rückkopplungspfeifen. Dies liegt daran, dass die Schrittweite im Falle eines Rückkopplungspfeifens nicht reduziert wird, was zu einer deutlich besseren Unterdrückungsleistung führt gegenüber Rückkopplungskompensatoren, die in einem langsamen Modus arbeiten. Äußerst vorteilhaft ist außerdem, wenn die erfindungsgemäße Schrittweitensteuerung unabhängig in den Teilfrequenzbändern erfolgt, um die Rückkopplungsunterdrückungsleistung in Zeitfrequenzbereichen, die keine tonalen Signale enthalten, beizubehalten.

## Patentansprüche

1. Verfahren zur Steuerung einer Adaptionsschrittweite eines adaptiven Filters (8) einer Hörvorrichtung für eine Rückkopplungsreduktion durch

    - Aufnehmen eines Schallsignals durch ein Mikrofon (2) der Hörvorrichtung und Ausgeben eines korrespondierenden Mikrofonsignals (m),
    - Erzeugen eines Hörersignals (x') für einen Hörer (4) der Hörvorrichtung auf der Basis des Mikrofonsignals (m)
    - Verschieben einer Frequenz eines auf der Basis des Mikrofonsignals (m) gewonnenen Ausgangssignals (x) bei dem Erzeugen des Hörersignals (x'), und
    - Reduzieren eines Rückkopplungssignals (r) in dem Mikrofonsignal (m) durch das adaptive Filter (8), **gekennzeichnet durch**
    - Gewinnen eines Autokorrelationswerts (a) von Abtastwerten des Mikrofonsignals (m), zwischen denen eine Zeitdifferenz (k) besteht,
    - Steuern der Adaptionsschrittweite ($\mu$) des adaptiven Filters (8) anhand des Autokorrelationswerts (a), und
    - Steuern der Zeitdifferenz (k) für das Gewinnen des Autokorrelationswerts (a) in Abhängigkeit von dem Verschieben der Frequenz des Ausgangssignals (x),

    wobei die Adaptionsschrittweite ($\mu$) ausgehend von einem Anfangswert nur dann reduziert wird, wenn der Autokorrelationswert (a) nach einer Normierung mit dem Normkorrelationswert, der sich bei der Zeitdifferenz (k) Null ergibt, in einem vorgegebenen Bereich um Eins liegt.

2. Verfahren nach Anspruch 1, wobei das Erzeugen des Hörersignals (x') aus dem Mikrofonsignal (m) mit einer Zeitverzögerung (d) erfolgt, die zum Steuern der Zeitdifferenz (k) für das Gewinnen des Autokorrelationswerts (a) herangezogen wird.

3. Verfahren nach Anspruch 1 oder 2, wobei das Steuern der Zeitdifferenz (k) für das Gewinnen des Autokorrelationswerts (a) derart erfolgt, dass der Autokorrelationswert im Fall von Rückkopplungspfeifen (a) unter einem vorgegebenen Schwellwert liegt.

4. Verfahren nach Anspruch 1 oder 2, wobei das Steuern der Zeitdifferenz (k) für das Gewinnen des Autokorrelationswerts (a) derart erfolgt, dass der Autokorrelationswert (a) im Fall von Rückkopplungspfeifen ein Minimum annimmt.

5. Verfahren nach einem der vorhergehenden Ansprüche, wobei das Steuern der Zeitdifferenz (k) für das Gewinnen des Autokorrelationswerts (a) dynamisch mit einer Änderung des Verschiebens der Frequenz des Ausgangssignals (x) erfolgt.

**6.** Verfahren nach einem der vorhergehenden Ansprüche, das in mehreren Frequenzteilbändern parallel, jeweils unabhängig voneinander durchgeführt wird.

**7.** Verfahren nach einem der vorhergehenden Ansprüche, wobei der Autokorrelationswert (a) nicht von Abtastwerten des Mikrofonsignals (m), sondern von Abtastwerten eines Fehlersignals (e) gewonnen wird, das einer Differenz zwischen dem Mikrofonsignal (m) und einem Korrektursignal (c) des adaptiven Filters (8) entspricht.

**8.** Hörvorrichtung mit

- einem Mikrofon (2) zum Aufnehmen eines Schallsignals und Ausgeben eines korrespondierenden Mikrofonsignals (m),
- einem Hörer (4),
- einer Signalverarbeitungseinrichtung (3) zum Erzeugen eines Hörersignals (x') für den Hörer (4) auf der Basis des Mikrofonsignals (m), und
- einem adaptiven Filter (8) zum Reduzieren eines Rückkopplungssignals (r) in dem Mikrofonsignal (m), wobei
- von der Signalverarbeitungseinrichtung (3) eine Frequenz eines auf der Basis des Mikrofonsignals (m) gewonnenen Ausgangssignals (x) bei dem Erzeugen des Hörersignals (x') verschiebbar ist,
**gekennzeichnet durch**
- eine Autokorrelationseinheit (11) zum Gewinnen eines Autokorrelationswerts (a) von Abtastwerten des Mikrofonsignals (m), zwischen denen eine Zeitdifferenz (k) besteht, und
- eine Steuereinrichtung zum Steuern einer Adaptionsschrittweite ($\mu$) des adaptiven Filters (8)anhand des Autokorrelationswerts (a), wobei
- in der Autokorrelationseinheit (11) die Zeitdifferenz (k) für das Gewinnen des Autokorrelationswerts (a) in Abhängigkeit von dem Verschieben der Frequenz des Ausgangssignals (x) steuerbar ist, und
- in der Steuereinrichtung die Adaptionsschrittweite ($\mu$) ausgehend von einem Anfangswert reduzierbar ist, wenn der Autokorrelationswert (a) nach einer Normierung mit dem Normkorrelationswert, der sich bei der Zeitdifferenz (k) Null ergibt, in einem vorgegebenen Bereich um Eins liegt.

**9.** Hörvorrichtung nach Anspruch 8, die als Hörgerät ausgebildet ist.

**Claims**

**1.** Method for controlling an adaptation step size of an adaptive filter (8) and a hearing apparatus for feedback reduction by

- picking up a sound signal by means of a microphone (2) of the hearing apparatus and outputting a corresponding microphone signal (m),
- generating a receiver signal (x') for a receiver (4) of the hearing apparatus on the basis of the microphone signal (m),
- shifting a frequency of an output signal (x) obtained on the basis of the microphone signal (m) when the receiver signal (x') is generated, and
- reducing a feedback signal (r) in the microphone signal (m) by means of the adaptive filter (8), **characterized by**
- obtainment of an autocorrelation value (a) from samples of the microphone signal (m) between which there is a time difference (k),
- control of the adaptation step size ($\mu$) of the adaptive filter (8) on the basis of the autocorrelation value (a), and
- control of the time difference (k) for obtaining the autocorrelation value (a) on the basis of the shifting of the frequency of the output signal (x), wherein the adaptation step size ($\mu$) is reduced from an initial value only if the autocorrelation value (a) is in a prescribed range around unity after normalization with the normal correlation value obtained for the time difference (k) zero.

**2.** Method according to Claim 1, wherein the receiver signal (x') is generated from the microphone signal (m) with a time delay (d) that is used to control the time difference (k) for obtaining the autocorrelation value (a) .

**3.** Method according to Claim 1 or 2, wherein the time difference (k) for obtaining the autocorrelation value (a) is controlled such that the autocorrelation value is below a prescribed threshold value in the case of feedback whistling (a).

4. Method according to Claim 1 or 2, wherein the time difference (k) for obtaining the autocorrelation value (a) is controlled such that the autocorrelation value (a) assumes a minimum in the case of feedback whistling.

5. Method according to one of the preceding claims, wherein the time difference (k) for obtaining the autocorrelation value (a) is controlled dynamically with a change in the shifting of the frequency of the output signal (x).

6. Method according to one of the preceding claims, which is performed in multiple frequency sub-bands in parallel, in each case independently of one another.

7. Method according to one of the preceding claims, wherein the autocorrelation value (a) is obtained not from samples of the microphone signal (m) but rather from samples of an error signal (e) consistent with a difference between the microphone signal (m) and a correction signal (c) of the adaptive filter (8).

8. Hearing apparatus having

  - a microphone (2) for picking up a sound signal and outputting a corresponding microphone signal (m),
  - a receiver (4),
  - a signal processing device (3) for generating a receiver signal (x') for the receiver (4) on the basis of the microphone single (m), and
  - an adaptive filter (8) for reducing a feedback signal (r) in the microphone signal (m), wherein
  - a frequency of an output signal (x) obtained on the basis of the microphone signal (m) is shiftable by the signal processing device (3) when the receiver signal (x') is generated,
  **characterized by**
  - an autocorrelation unit (11) for obtaining an autocorrelation value (a) from samples of the microphone signal (m) between which there is a time difference (k), and
  - a control device for controlling an adaptation step size ($\mu$) of the adaptive filter (8) on the basis of the autocorrelation value (a), wherein
  - the time difference (k) for obtaining the autocorrelation value (a) is controllable in the autocorrelation unit (11) on the basis of the shifting of the frequency of the output signal (x), and
  - the adaptation step size ($\mu$) is reducible from an initial value in the control device if the autocorrelation value (a) is in a prescribed range around unity after normalization with the normal correlation value obtained for the time difference (k) zero.

9. Hearing apparatus according to Claim 8, which is in the form of a hearing device.

**Revendications**

1. Procédé de commande d'un pas d'adaptation d'un filtre adaptatif (8) d'un dispositif auditif pour une réduction d'une rétroaction, comprenant

  - l'acquisition d'un signal sonore par l'intermédiaire d'un microphone (2) du dispositif auditif et l'émission d'un signal de microphone correspondant (m),
  - la génération d'un signal d'écouteur (x') destiné à un écouteur (4) du dispositif auditif sur la base du signal du microphone (m),
  - le décalage d'une fréquence d'un signal de sortie (x) obtenu sur la base du signal de microphone (m) lors de la génération du signal d'écouteur (x'), et
  - la réduction d'un signal de rétroaction (r) dans le signal de microphone (m) par le filtre adaptatif (8), **caractérisé par**
  - l'obtention d'une valeur d'autocorrélation (a) d'échantillons du signal de microphone (m) entre lesquels il existe une différence de temps (k),
  - la commande du pas d'adaptation ($\mu$) du filtre adaptatif (8) par utilisation de la valeur d'autocorrélation (a), et
  - la commande de la différence de temps (k) pour l'obtention de la valeur d'autocorrélation (a) en fonction du décalage de la fréquence du signal de sortie (x),

dans lequel le pas d'adaptation ($\mu$) n'est réduit à partir d'une valeur initiale que si la valeur d'autocorrélation (a), après normalisation par la valeur de corrélation de normalisation obtenue lorsque la différence de temps (k) est égale à zéro, se situe dans une plage prédéterminée centrée sur un.

2. Procédé selon la revendication 1, dans lequel la génération du signal d'écouteur (x') à partir du signal de microphone (m) est effectuée avec un temps de retard (d) qui est utilisé afin de commander la différence de temps (k) pour l'obtention de la valeur d'autocorrélation (a).

3. Procédé selon la revendication 1 ou 2, dans lequel la différence de temps (k) pour l'obtention de la valeur d'autocorrélation (a) est commandée de manière à ce que la valeur d'autocorrélation, dans le cas de sifflets de rétroaction (a), soit inférieure à une valeur de seuil prédéterminée.

4. Procédé selon la revendication 1 ou 2, dans lequel la différence de temps (k) pour l'obtention de la valeur d'autocorrélation (a) est commandée de manière à ce que la valeur d'autocorrélation (a) se situe à un minimum dans le cas de sifflets de rétroaction.

5. Procédé selon l'une des revendications précédentes, dans lequel la différence de temps (k) pour l'obtention de la valeur d'autocorrélation (a) est commandée dynamiquement par une modification du décalage de fréquence du signal de sortie (x).

6. Procédé selon l'une des revendications précédentes, qui est mis en oeuvre en parallèle dans plusieurs sous-bandes de fréquences, chacune indépendamment l'une de l'autre.

7. Procédé selon l'une des revendications précédentes, dans lequel la valeur d'autocorrélation (a) n'est pas obtenue à partir d'échantillons du signal de microphone (m) mais à partir d'échantillons d'un signal d'erreur (e) correspondant à une différence entre le signal de microphone (m) et un signal de correction (c) du filtre adaptatif (8).

8. Dispositif auditif comportant

- un microphone (2) pour l'acquisition d'un signal sonore et la fourniture en sortie d'un signal de microphone correspondant (m),
- un écouteur (4),
- un moyen de traitement de signal (3) pour générer un signal de réception (x') destiné à l'écouteur (4) sur la base du signal de microphone (m), et
- un filtre adaptatif (8) pour la réduction d'un signal de rétroaction (r) dans le signal du microphone (m), dans lequel une fréquence d'un signal de sortie (x) obtenu sur la base du signal de microphone (m) peut être décalée par le dispositif de traitement de signal (3) lorsque le signal d'écouteur (x') est généré, **caractérisé par**
- une unité d'autocorrélation (11) pour l'obtention d'une valeur d'autocorrélation (a) d'échantillons du signal de microphone (m) entre lesquels il existe une différence de temps (k), et
- un dispositif de commande pour la commande d'un pas d'adaptation ($\mu$) du filtre adaptatif (8) sur la base de la valeur d'autocorrélation (a),
dans lequel
- la différence de temps (k) pour l'obtention de la valeur d'autocorrélation (a) peut être commandée dans l'unité d'autocorrélation (11) en fonction du décalage de la fréquence du signal de sortie (x), et
- le pas d'adaptation ($\mu$) peut être réduit dans le dispositif de commande à partir d'une valeur initiale si la valeur d'autocorrélation (a), après normalisation par la valeur de corrélation de normalisation obtenue lorsque la différence de temps (k) est égale à zéro, se situe dans une plage prédéterminée centrée sur un.

9. Dispositif auditif selon la revendication 8, qui est réalisé sous la forme d'un appareil auditif.

# FIG 1

(Stand der Technik)

## FIG 2
(Stand der Technik)

## FIG 3

FIG 4

**EP 2 797 344 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102010025918 A1

- US 20090028367 A1

**In der Beschreibung aufgeführte Nicht-Patentliteratur**

- Normalized Least-Mean-Square Adaptive Filters. **S. HAYKIN.** Adaptive Filter Theory. Prentice Hall, 1999, 320-324

- **TOON VAN WATERSCHOOT ; MARC MOONEN.** Fifty years of acoustic feedback control: state of the art and future challenges. *Proc. IEEE,* Februar 2011, vol. 99 (2), 288-327